# EUROPÄISCHE PATENTSCHRIFT

(11) **EP 3 601 631 B1**
(45) Veröffentlichungstag und Bekanntmachung des Hinweises auf die Patenterteilung: **22.11.2023**
(21) Anmeldenummer: 18710005.2
(22) Anmeldetag: 06.03.2018
(51) Int. Cl.: C23C 16/458, C23C 16/46

(54) **SUSZEPTOR FÜR EINEN CVD-REAKTOR**
SUSCEPTOR FOR A CVD REACTOR
SUSCEPTEUR DESTINÉ À UN RÉACTEUR DE DÉPÔT CHIMIQUE EN PHASE VAPEUR

(30) Priorität: 20.03.2017 DE 102017105947
(43) Veröffentlichungstag der Anmeldung: 05.02.2020
(73) Patentinhaber: Aixtron SE, 52134 Herzogenrath (DE)
(72) Erfinder: SCHÖN, Oliver, 52134 Herzogenrath (DE); RUDA Y WITT, Francisco, 52249 Eschweiler (DE); SCHAFFRATH, Marcus, 52477 Alsdorf (DE)
(74) Vertreter: Grundmann, Dirk
(86) Internationale Anmeldenummer: PCT/EP2018/055457
(87) Internationale Veröffentlichungsnummer: WO 2018/172063

(56) Entgegenhaltungen:
- EP-A1- 2 963 676
- WO-A1-03/069029
- WO-A1-2011/045241
- US-A1- 2002 090 454
- US-A1- 2005 051 099
- US-A1- 2007 062 455
- US-A1- 2009 272 323
- US-A1- 2012 204 796

## Beschreibung

### Gebiet der Technik

Die Erfindung betrifft einen Suszeptor für einen CVD-Reaktor, bestehend aus einem flachen Körper mit zumindest einem auf einer Breitseite angeordneten kreisförmigen Flächenabschnitt, auf dem ein Substrathalter gelagert ist, wobei der Flächenabschnitt in Richtung auf den Substrathalter offene Kanäle aufweist, die mit einer am Ende einer Gaszuleitung angeordneten Einspeiseöffnung strömungsverbunden sind.

Die Erfindung betrifft darüber hinaus die Verwendung eines Suszeptors und eine aus einem Substrathalter und einem Suszeptor ausgebildete Suszeptoranordnung.

### Stand der Technik

Die WO 2011/045241 A1 offenbart einen CVD-Reaktor mit einem Suszeptor, wobei der Suszeptor eine Tasche aufweist, in der ein Substrathalter einliegt. In die Tasche kann ein Spülgas eingespeist werden. In dem Boden der Tasche angeordnete spiralförmige Kanäle verleihen dem eingespeisten Spülgas eine Richtung, so dass ein vom Spülgas erzeugtes Gaspolster den Substrathalter drehantreiben kann. In einer um das Zentrum der Tasche angeordneten Vertiefung steckt ein ringförmiger Dichtring, der die Fläche der Tasche in zwei Zonen unterteilt.

Aus der EP 0 242 898 B1 ist ein CVD-Reaktor bekannt, bei dem in einem Reaktorgehäuse ein Suszeptor angeordnet ist, der von einer Heizeinrichtung von unten beheizbar ist. Der Suszeptor besitzt mehrere kreisförmige Flächenabschnitte, auf denen jeweils ein Substrathalter angeordnet ist, der eine Kreisscheibenform besitzt. In das Zentrum des Flächenabschnitts mündet eine Gaszuleitung. Die bildet dort drei Einspeiseöffnungen aus, die jeweils mit einem radial innenliegenden Ende spiralförmig sich um das Zentrum erstreckender Kanäle verbunden ist. Die Kanäle sind zur Ebene, in der sich der Flächenabschnitt erstreckt, offen, werden aber nach oben von einem Substrathalter überdeckt. Wird durch die Einspeiseöffnungen ein Spülgas in den Zwischenraum zwischen der Unterseite des Substrathalters und der Ebene des Flächenabschnitts gebracht, so wird der Substrathalter in eine Lüftungsstellung angehoben, in der er auf einem Gaspolster gelagert ist. Als Folge der spiralartigen Anordnung der Kanäle in der Ebene bildet sich ein gerichteter Gasstrom im Gasspalt zwischen Substrathalter und der Auflageebene des Flächenabschnittes aus, so dass der Substrathalter, der ein oder mehrere Substrate trägt, in eine Drehung versetzt wird. Die Gaseinspeisung erfolgt hier im Zentrum des kreisscheibenförmigen Suszeptors.

Ein anderes Konzept der Gaseinspeisung verfolgt ein CVD-Reaktor, dessen Suszeptor in der DE 10 2014 100 024 A1 beschrieben ist. Dort wird das Prozessgas von einer duschkopfartigen, sich über die gesamte Fläche des Suszeptors erstreckende Gasaustrittsfläche in die Prozesskammer eingebracht. Auch hier wird der Suszeptor von unten mit Heizenergie versorgt. Die Substrate liegen hier aber nicht auf drehbaren Substrathaltern, sondern in Taschen, die von unmittelbar in den Suszeptor eingearbeiteten Vertiefungen ausgebildet sind. Zur Beeinflussung des Wärmeflusses vom Suszeptor zum Substrat besitzt der Boden der Tasche eine Tiefenprofilierung. Der Rand des Substrates ruht dabei auf Stützrippen oder anderweitigen Stützvorsprüngen.

Die DE 10 2014 103 505 A1 offenbart Einsatzstücke im Suszeptor, die bei der Fertigung einer Beschichtung verwendet werden.

Bei einer gattungsgemäßen Vorrichtung wird permanent Wärme vom Suszeptor in einen Substrathalter transportiert, von dem die Wärme zu einer dem Substrathalter gegenüberliegenden gekühlten Prozesskammer transportiert wird. Der Wärmefluss wird u.a. von den optischen Eigenschaften des auf dem Substrathalter aufliegenden Substrates beeinflusst. Ist das Substrat für Infrarotstrahlung transparent, kann dies zu einer Temperaturabsenkung im Zentralbereich des Substrathalters führen. Ist das Substrat aber bspw. ein SiliziumSubstrat reflektierend, dann sind die Temperaturen mittig unter dem Substrat größer als in der Nähe des Randes des Substrathalters. In diesem Fall muss das Zentrum gegenüber dem Rand gekühlt werden. Alternativ dazu kann der Rand auch gegenüber dem Zentrum erwärmt werden.

### Zusammenfassung der Erfindung

Der Erfindung liegt die Aufgabe zugrunde, einen gattungsgemäßen Suszeptor, bei dem in einen Spalt zwischen Suszeptoroberseite und Unterseite eines Substrathalters ein Spülgas eingespeist wird, eine lokale Temperaturinhomogenität des Substrathalters und insbesondere eine Abweichung der Temperatur im Zentrum des Substrathalters von der Temperatur am Rande des Substrathalters mit einfachen Mitteln zu kompensieren.

Gelöst wird die Aufgabe durch die in den Ansprüchen angegebene Erfindung. Zunächst und im Wesentlichen wird vorgeschlagen, dass in dem Flächenabschnitt, der für die Lagerung der Substrathalter vorgesehen ist, nicht nur die sich insbesondere spiralartig um ein Zentrum angeordneten Kanäle zum Erzeugen des Gasdrehlagers, sondern auch Wärmeübertragungs-Beeinflussungselemente vorgesehen sind. Die Beeinflussungselemente sind derart angeordnet, dass sie lokal den Wärmefluss vom Substrat zum Substrathalter beeinflussen können. Sie sind entweder als Erhebungen, Vertiefungen oder als in Vertiefungen einsteckende Einsätze ausgebildet. In einer ersten Variante, in der die Beeinflussungselemente als offene Vertiefungen ausgebildet sind, bilden sie einen Vertiefungsboden aus, der sich bevorzugt parallel zur Erstreckungsebene des Flächenabschnittes erstreckt oder geeignet profiliert ist. Handelt es sich bei den Beeinflussungselementen um Erhebungen, so treten sie sockelhaft aus dem Flächenabschnitt heraus, wobei der Boden der Erhebung oberhalb des insbesondere ebenen Flächenabschnittes liegt. Der Boden ist durch eine Abstandsstrecke von der Ebene beabstandet und kann von einer kontinuierlich umlaufenden Wand umgeben sein. Die Wand hat durchgehend die Höhe des Abstandes (Abstandsstrecke) zwischen Boden der Erhebung oder Vertiefung und der den Rand der Vertiefung bildenden Ebene. Ebenso wie der Boden, ist bevorzugt auch die Wand durchgängig geschlossen und bildet bevorzugt keine Öffnung, so dass durch Wand oder Boden weder Gas in die Vertiefung eintreten, noch Gas aus der Wand oder dem Boden aus der Vertiefung austreten kann. Gleichwohl können die Vertiefungen aber auch strömungstechnisch mit einem der Kanäle verbunden sein, wobei allerdings diese strömungstechnische Verbindung so ausgebildet ist, dass sich innerhalb der Vertiefung kein nennenswerter Gasstrom ausbildet. In den Kanälen soll sich aber eine Gasströmung entwickeln, deren Ziel der Drehantrieb des Substrathalters ist. Hierzu erzeugen die Kanäle einen Gasstrom mit einer azimutalen Geschwindigkeitskomponente. Um einem im Zentrum eingespeisten Gasstrom die drehantreibende Geschwindigkeitskomponente zu geben, kann sich der Kanal auf einer Spiralbogenlinie erstrecken. Es ist aber auch möglich, dass der Kanal lediglich von Öffnungen ausgebildet wird, aus denen ein gerichteter Gasstrom austritt. Beim Betrieb wird der Substrathalter durch den in die Kanäle eingespeisten Gasstrom in eine Lüftungsstellung angehoben, wobei der Spalt zwischen der Ebene und der Unterseite des Substrathalters eine gewisse Abdichtung hinsichtlich des Austritts der Gase aus den Kanälen bewirkt, wozu insbesondere vorgesehen ist, dass die Unterseite des Substrathalters über ihre gesamte Fläche im Wesentlichen plan verläuft. Die Unterseite kann aber auch gewölbt sein oder eine andere Struktur aufweisen. Die Strömung bildet sich somit im Wesentlichen im Kanal aus. Die Richtung des Kanales zwingt der Gasströmung eine azimutale Komponente auf. Dies wird bevorzugt dadurch erreicht, dass sich die Kanäle auf einer archimedischen Spirale erstrecken. In einer Variante der Erfindung sind Einsätze vorgesehen, die in Vertiefungen stecken. Diese Einsätze sind bevorzugt aus einem Werkstoff gefertigt, der eine andere Wärmeleitfähigkeit besitzt als der Suszeptor, welcher bevorzugt aus Graphit besteht. Die bevorzugt in einer mehrzähligen, bevorzugt dreizähligen Symmetrie um das Zentrum angeordneten Kanäle erstrecken sich jeweils auf einer Bogenlinie, wobei die Kanäle eine derartige Länge und die Bogenlinien einen derartigen Verlauf haben können, dass eine durch das Zentrum gehende Radiallinie mehrere Kanäle schneiden kann, so dass die Radiale durch einen radial innenliegenden Abschnitt eines ersten Kanales und durch einen radial außenliegenden Abschnitt eines zweiten Kanales verläuft. Bevorzugt bildet der Flächenabschnitt erste Kreissektoren, in denen mindestens zwei Kanäle verlaufen. Diesen ersten Kreissektoren können zweite Kreissektoren benachbart sein, durch welche jeweils nur ein Kanal verläuft. In einer bevorzugten Ausgestaltung der Erfindung erstrecken sich die Beeinflussungselemente bevorzugt vollständig oder zumindest bereichsweise in den ersten Kreissektoren. Sie können sich aber auch vollständig oder bereichsweise in den zweiten Kreissektoren erstrecken. Die Summe der Winkel, über die sich die ersten Kreissektoren erstrecken, beträgt bevorzugt mehr als 180°. Die Summe der Winkel, über die sich die zweiten Kreissektoren erstrecken, beträgt bevorzugt mehr als 90°. Die Winkelsumme der ersten Kreissektoren ist bevorzugt größer als die Winkelsumme der zweiten Kreissektoren. Die beiden Enden der Beeinflussungselemente können in voneinander verschiedenen ersten Kreissektoren liegen, so dass sich die Beeinflussungselemente durch ein zweites Kreissegment hindurch erstrecken. In einer Weiterbildung der Erfindung ist vorgesehen, dass die Beeinflussungselemente im ersten Kreissektor und/ oder im zweiten Kreissektor zwischen zwei Kanälen verlaufen oder aber auch radial außerhalb der beiden Kanäle. Das Beeinflussungselement kann sich auf einer Bogenlinie erstrecken, die dem Verlauf der Bogenlinie ähnlich ist, entlang der sich der Kanal erstreckt. Die Beeinflussungselemente können sich somit auf spiralförmig verlaufenden Bogenlinien, aber auch auf frei geformten Bogenlinien erstrecken. Sie können sich auf einer spiralförmigen Bogenlinie verlaufend dem radial äußeren Ende eines Kanales anschließen, also insbesondere auf der Verlängerung der Bogenlinie, auf der der Kanal verläuft, verlaufen. Es ist aber auch vorgesehen, dass sich die Vertiefungen radial einwärts versetzt zum radial äußeren Ende des Kanals beginnend auf einer spiralförmigen Bogenlinie erstrecken. Die ergänzend in einen Flächenabschnitt eingebrachten Beeinflussungselemente haben die Wirkung, den Wärmefluss zu einem in einer Tasche des Suszeptors einliegenden Substrathalter, deren Boden vom Flächenabschnitt gebildet ist, lokal zu beeinflussen. Dies erfolgt entweder durch eine Verminderung des Wärmeflusses, indem das Beeinflussungselement als Vertiefung ausgebildet ist, oder durch eine Erhöhung des Wärmeflusses, indem das Beeinflussungselement ein Einsatz ist, der eine höhere spezifische Leitfähigkeit aufweist, als der Suszeptor. Eine lokale Erhöhung des Wärmeflusses kann auch dadurch erreicht werden, dass die Beeinflussungselemente als Erhebungen ausgebildet sind. Sie ragen in den Spalt zwischen der Unterseite des Substratträgers und dem Flächenabschnitt. Der das Gasdrehlager bildende Spalt zwischen der Unterseite des Substrathalters und dem Flächenabschnitt ist dadurch lokal kleiner. Die Erhebungen können insbesondere von in Vertiefungen einsteckenden Einsätzen gebildet sein. Es handelt sich insbesondere um inselförmige Überstände innerhalb des vom Substrathalter überdeckten Flächenabschnitts. Die Kanäle besitzen einen derartigen Verlauf in der ansonsten bis auf die Vertiefungen ebenen oder planen Flächenabschnitte, dass sich ein eine azimutale Geschwindigkeitskomponente aufweisender Gasstrom bildet, der den Substrathalter drehantreibt. Bevorzugt verlaufen die Kanäle spiralartig um das Zentrum des jeweiligen Flächenabschnitts. In einer Variante der Erfindung ist vorgesehen, dass die Vertiefungen unterschiedliche Höhen aufweisen. So ist insbesondere vorgesehen, dass die Tiefe der Vertiefungen im Zentralbereich höher ist als im Randbereich, so dass im Zentralbereich ein hoher Wärme-übertragungswiderstand realisiert ist und im Randbereich ein geringerer Wärmeübertragungswiderstand. Aufgrund der Drehung des Substrathalters über dem Flächenabschnitt können Zonen mit verschiedenen Wärmeübertragungseigenschaften azimutal nebeneinander angeordnet sein. Die Beeinflussungselemente sind insbesondere in den Zwischenräumen zwischen benachbarten Kanälen angeordnet. Die Beeinflussungselemente können auch von ein oder mehreren inselförmigen Vertiefungen ausgebildet sein, wobei bevorzugt mehrere inselartige Vertiefungen in einer Kette hintereinander angeordnet sind, wobei sich eine Mehrzahl derartiger Vertiefungen auf einer länglichen Fläche erstrecken. Es kann sich dabei auch um eine Kreisbogenfläche handeln. Die Vertiefungen werden bevorzugt von kreisrunden Öffnungen ausgebildet, so dass sie in einfacher Weise mit einem Stirnfräser oder einem Bohrer gefertigt werden können. Die Vertiefungen können darüber hinaus auch parallel oder seitlich versetzt angeordnet sein. Die Beeinflussungselemente können auch einen mehrkantigen, insbesondere dreikantigen Grundriss aufweisen. Die Anordnung der Beeinflussungselemente im Flächenabschnitt kann entsprechend einer mehrzähligen Symmetrie erfolgen. Es sind aber auch nicht symmetrische Varianten vorgesehen, bei denen die Beeinflussungselemente ohne Symmetrie angeordnet sind. Die Einsätze können so ausgebildet sein, dass ihre freie Stirnseite bündig in der den Einsatz umgebenden Fläche liegt. Die Einsätze können aber auch eine geringere oder größere Höhe besitzen als die Tiefe der Vertiefung, so dass ihre Stirnflächen den Boden einer Vertiefung bilden können oder den Boden einer Erhebung ausbilden können. Es können Einsätze verwendet werden, die einen höheren spezifischen Wärmeleitwert aufweisen als der des umgebenden Suszeptors oder aber auch Einsätze, die einen geringeren spezifischen Wärmeleitwert besitzen als der Suszeptor.

Sofern die ein oder mehreren, die lokale Wärmeübertragung beeinflussenden Beeinflussungselemente, Vertiefungen sind, sind diese Vertiefungen konstruktiv derart von den Kanälen verschieden, dass sich in Ihnen beim ordnungsgemäßen Betrieb der Vorrichtung, bei den durch Einspeisen eines Gasstroms in die jeweiligen Kanäle der Substrathalter in eine Lüftungsstellung angehoben und drehangetrieben wird, keine aktive Strömung ausbildet. Die offenen Vertiefungen sind derart ausgebildet und angeordnet, dass sich darin allenfalls eine induzierte Strömung oder eine einen Druckausgleich bewirkende Strömung ausbildet, die aber keinesfalls ausreicht, um für sich, ohne die in die Kanäle eingespeisten Gasströme, den Substrathalter anzuheben oder drehanzutreiben. Es gibt somit insbesondere keine Strömung durch eine Vertiefung hindurch. Es können sich allenfalls Druckausgleichsströmungen in die Vertiefung hinein oder aus ihr heraus ausbilden.

### Kurze Beschreibung der Zeichnungen

Ausführungsbeispiele der Erfindung werden nachfolgend anhand beigefügter Zeichnungen erläutert. Es zeigen:

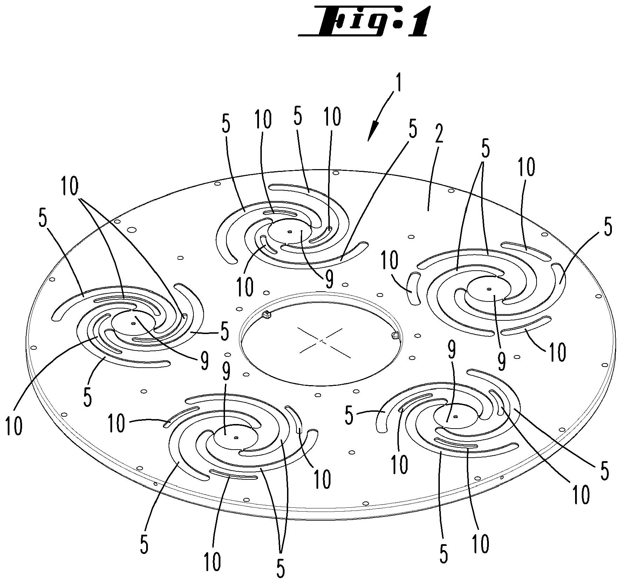

- Fig. 1: eine perspektivische Darstellung eines Suszeptors, wie er in einem CVD-Reaktor verwendet wird, mit fünf kreisförmigen Flächenabschnitten 3 jeweils zur Ausbildung eines Bodens einer Tasche zur Aufnahme eines Substrathalters, in der Darstellung besitzt jeder kreisförmige Flächenabschnitt zur Vereinfachung der zeichnerischen Darstellungen jeweils anders gestaltete Beeinflussungselemente, bevorzugt sind die einem Suszeptor zugeordneten kreisförmigen Flächenabschnitte 3 aber untereinander gleich gestaltet,
- Fig. 2: die Draufsicht auf den Suszeptor 1,
- Fig. 3: den Ausschnitt III in Figur 2,
- Fig. 4: einen Schnitt gemäß der Schnittlinie IV-IV in Figur 3,
- Fig. 5: den Ausschnitt V in Figur 2,
- Fig. 6: den Ausschnitt VI in Figur 2,
- Fig. 7: eine Darstellung gemäß Figur 4, wobei in einer Vertiefung 10 ein Einsatz 11 steckt,
- Fig. 8: schematisch einen Vertikalschnitt durch einen CVD-Reaktor mit einem Suszeptor gemäß einem der Ausführungsbeispiele,
- Fig. 9: eine Darstellung gemäß Figur 5 eines weiteren Ausführungsbeispiels, bei dem die Vertiefungen 10 mit einer Gasverteilausnehmung 12 strömungsverbunden sind,
- Fig.10: ein weiteres Ausführungsbeispiel, bei dem die Vertiefungen 10 mit den Kanälen 5 strömungsverbunden sind,
- Fig. 11: ein weiteres Ausführungsbeispiel, bei dem die Vertiefungen eine Dreieckform aufweisen und
- Fig. 12: ein weiteres Ausführungsbeispiel, bei dem die Vertiefungen 10 als Zylinderbohrungen in einer Reihe hintereinander angeordnet sind.

### Beschreibung der Ausführungsformen

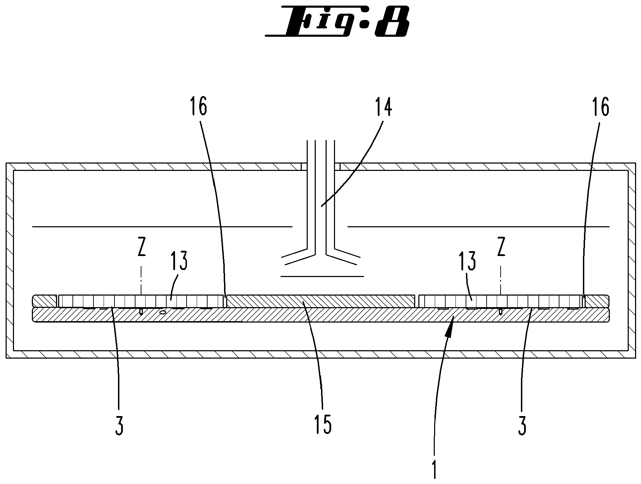

Die Figur 8 zeigt schematisch den wesentlichen Aufbau eines CVD-Reaktors. Eine Prozesskammer ist in einem nach außen gasdicht geschlossenen Reaktorgehäuse angeordnet und wird durch ein Gaseinlassorgan 14 mit Prozessgasen versorgt. Ein von unten beheizter Suszeptor 1 besitzt mehrere Flächenabschnitte 3, die jeweils den Boden einer Tasche 16 ausbilden, in der ein Substrathalter 13 angeordnet ist, dessen Oberseite zur Prozesskammer weist und ein oder mehrere Substrate trägt. Durch Einspeisen eines Spülgases in den Spalt zwischen Unterseite des Substrathalters 13 und Flächenabschnitt 3 wird ein Gaspolster erzeugt, auf dem der Substrathalter 13 schwebt. Durch spiralförmig um ein Zentrum Z des Flächenabschnittes 3 angeordnete Kanäle 5 wird der eingespeiste Gasfluss in eine Drehbewegung versetzt, die den Substrathalter 13 drehantreibt.

Die Einspeisung des Spülgases durch eine im Bereich des Zentrums Z liegende Einspeiseöffnung 9 kann einen, in der Regel aber geringen, Einfluss auf die Homogenität des Temperaturverlaufs auf der zur Prozesskammerseite weisenden Oberfläche des Substrathalters zur Folge haben. Wesentlich wird der Temperaturverlauf aber von den Kanälen 5 beeinflusst, da der Spalt weitestgehend als thermischer Isolator wirkt. Eine wesentliche Beeinflussung des Temperaturprofils auf der zur Prozesskammer weisenden Oberfläche des Substrathalters hat das Substrat. Besitzt das Substrat reflektierende Eigenschaften, so kann es im Zentralbereich zu einer Temperaturüberhöhung kommen, so dass das Zentrum gegenüber dem Rand gekühlt werden muss. Alternativ kann aber auch der Rand gegenüber dem Zentrum erwärmt werden. Werden für Wärmestrahlung transparente Substrate verwendet, so stellt sich eine umgekehrte Problematik. Hier kann es randseitig zu einer Temperaturerhöhung kommen. Diese Temperaturinhomogenität soll erfindungsgemäß durch geeignete Maßnahmen kompensiert werden.

Die Ausführungsbeispiele zeigen hierzu Wärmefluss-Beeinflussungselemente, die als Vertiefungen 10 oder aus in Vertiefungen 10 steckenden Einsätzen 11 gebildet sind. Sind die Wärmebeeinflussungselemente als in Vertiefungen einsteckende Einsätze ausgebildet, so sind die Einsätze bevorzugt aus einem Werkstoff gefertigt, dessen Wärmeleitfähigkeit größer ist als die Wärmeleitfähigkeit des Werkstoffs, der die Vertiefungen ausbildet, also des Werkstoffs des Substrathalters 13, so dass dann die Wärmebeeinflussungselemente zu einer lokalen Erhöhung der Temperatur auf der Oberseite des Substrathalters führen. Sind die Wärmebeeinflussungselemente hingegen lediglich als Vertiefungen ausgebildet, so führen sie aufgrund der isolierenden Wirkung des sich in den Vertiefungen befindenden Gases zu einer Temperaturherabsetzung an der Oberseite des Substrathalters.

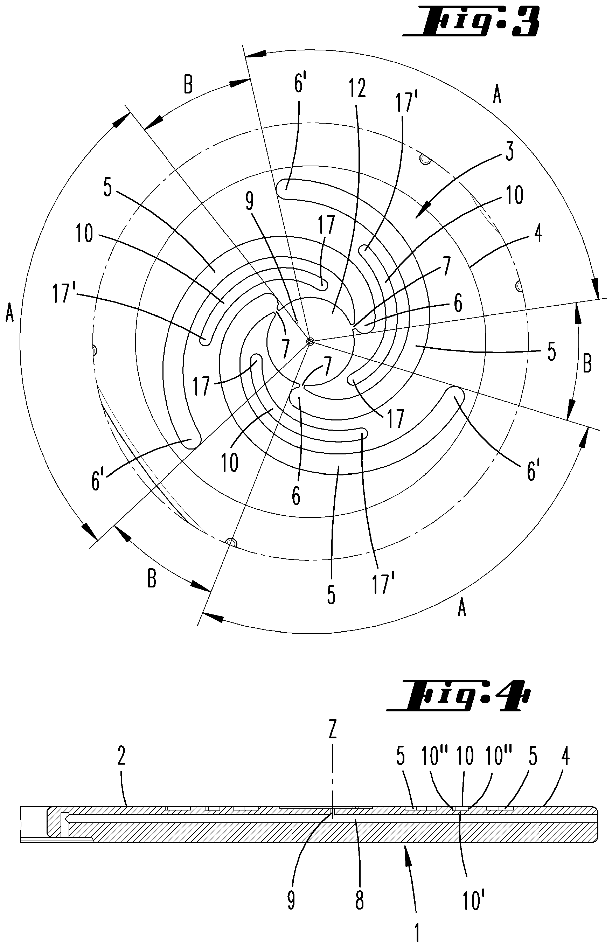

Der in der Figur 4 dargestellte Querschnitt zeigt ein Beeinflussungselement in Form einer Vertiefung 10, wobei die Vertiefung 10 einen Boden 10' und Wände 10" aufweist. Die Wände 10" werden jeweils von einer ununterbrochenen Fläche ausgebildet, die nach unten hin vom Boden 10' und nach oben hin vom Rand der Vertiefung 10 begrenzt ist. Die Böden 10' der Vertiefung 10 werden ebenfalls von ununterbrochenen Flächen ausgebildet, die durch den Rand des Bodens begrenzt sind. Aus den Wänden 10" und dem Boden 10' strömt somit kein Gas oder dergleichen in die Vertiefung 10. Ebenso wenig strömt Gas aus den Wänden 10" oder dem Boden 10' aus der Vertiefung 10 heraus.

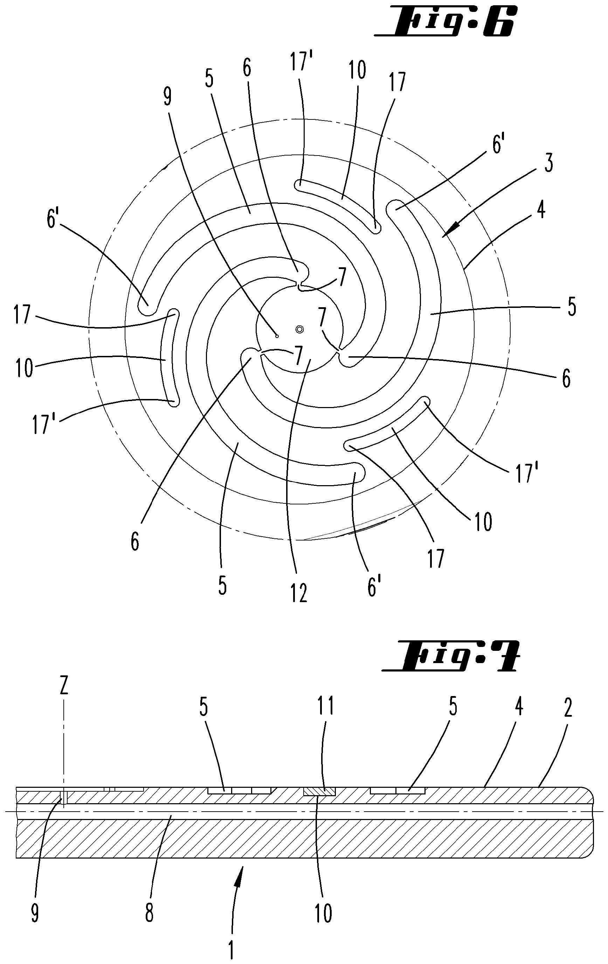

Die Figur 7 zeigt eine alternative Anordnung des Beeinflussungselementes. Es ist hier als körperlicher Einsatz 11 aus einem Festkörper ausgebildet, der im Wesentlichen formausfüllend in der Art einer Intarsie in eine Vertiefung 10 eingesetzt ist. Er besitzt eine andere spezifische Leitfähigkeit als das Material des ihn umgebenden Suszeptors 1.

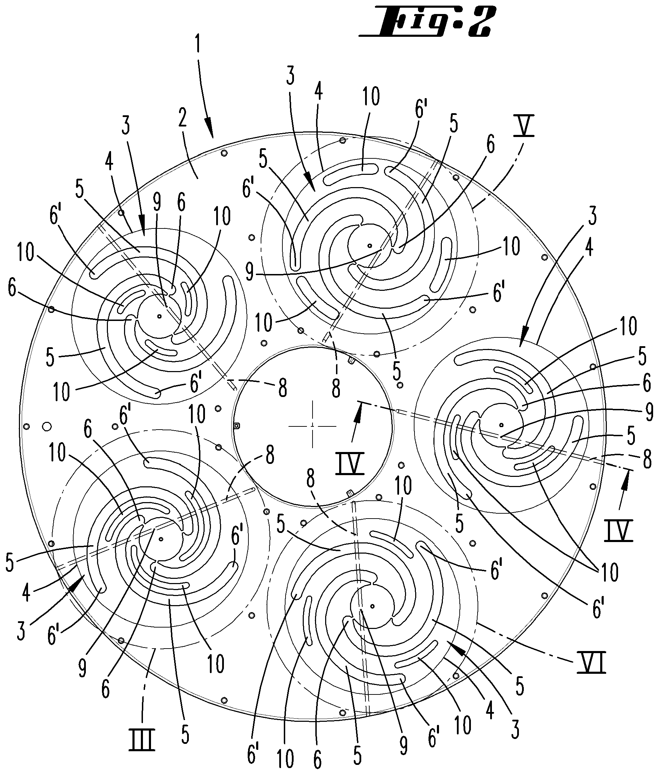

Die in den Figuren 2, 3, 5 und 6 dargestellten Vertiefungen 10 können in jeweils alternativen Ausführungsformen auch mit einem Einsatz 11 bestückt sein. Sie werden im Folgenden aber als zur Wärmeflussbeeinflussung angeordnete Vertiefungen 10 beschrieben.

Der in der Figur 2 dargestellte Suszeptor 1 besteht aus Graphit und hat eine Kreisscheibenform. Der Suszeptor 1 kann aber auch eine andere Form aufweisen, bspw. kann er mehrkantig ausgebildet sein. So ist die Ausgestaltung eines Suszeptors 1 in Rechteckform oder in Dreieckform auch vorgesehen. Die Anzahl der Kanten bzw. Ecken eines mehrkantigen Suszeptors kann dabei dieselbe sein wie die Anzahl der Flächenabschnitte 3, die bereits einen Substrathalter 13 aufnehmen. Es handelt sich bevorzugt um einen symmetrischen Mehrkant, wobei die Zähligkeit der Symmetrie der Anzahl der Flächenabschnitte 2 entspricht. Auf einem radial äußeren Ringbereich befinden sich in einer symmetrischen Anordnung mehrere, im Ausführungsbeispiel fünf jeweils durch eine Begrenzungslinie 4 begrenzte Flächenabschnitte 3, die jeweils den Boden einer Tasche 16 (vgl. Figur 8) bilden können. Im Zentrum Z des Flächenabschnittes 3 befindet sich eine Einspeiseöffnung 9, die mit einer Gaszuleitung 8 versehen ist, die als Bohrung innerhalb des Suszeptors 1 ausgebildet ist. Die Einspeiseöffnung 9 mündet in einer kreisrunden Gasverteilausnehmung 12, die als kreissymmetrische Vertiefung um das Zentrum Z ausgebildet ist.

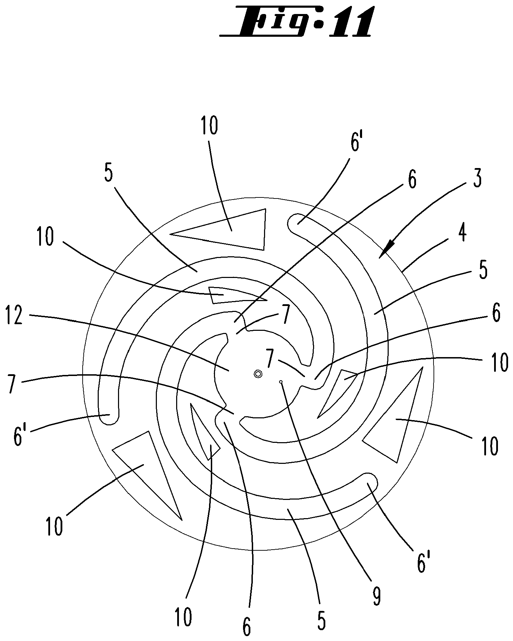

Die Gasverteilausnehmung 12 besitzt der Anzahl der Kanäle 5 entsprechende Kanalöffnungen 7, mit denen die Gasverteilausnehmung 12 mit jeweils einem Kanal 5 strömungsverbunden ist. Im Ausführungsbeispiel sind drei Kanäle 5 vorgesehen. Die Kanalöffnung 7 ist in den Zeichnungen als Verengung dargestellt. Es ist aber nicht erforderlich, dass die Kanalöffnung eine geringere Öffnungsweite aufweist als die Breite der Kanäle 5 (siehe Figur 11).

Die Kanäle 5 besitzen ein radial inneres Ende 6, das mit der Kanalöffnung 7 mit der Gasverteilausnehmung 12 strömungsverbunden ist. Die Kanäle 5 erstrecken sich auf einer Spirallinie um das Zentrum Z bis zu einem radial äußeren Ende 6'. Die Kanäle 5 erstrecken sich dabei über einen Bogenwinkel um das Zentrum Z, der größer ist als 180°. Zwischen jeweils benachbart zueinander verlaufenden Kanälen 5 erstreckt sich ein hier als Vertiefung 10 dargestelltes Beeinflussungselement. Die Vertiefung 10 erstreckt sich auf einer Bogenlänge von mindestens 30°, bevorzugt mindestens 60°, bevorzugt mindestens 90° um das Zentrum Z. Im Ausführungsbeispiel ist die Breite der Kanäle 5 geringfügig größer als die Breite der Vertiefung 10. Das radial innere Ende 17 der Vertiefung 10 liegt etwa auf demselben Radialabstand, auf dem auch das radial innere Ende 6 des Kanales liegt. Die Vertiefung 10 erstreckt sich im Bereich ihres radial außenliegenden Endes 17' etwa mittig zwischen den beiden benachbarten Kanälen 5.

Die Vertiefung 10 hat in den Ausführungsbeispielen der Figuren 3 bis 7 die Form eines länglichen Grabens. Es ist aber auch vorgesehen, dass auf einer länglichen Grundfläche eine Vielzahl von Einzelvertiefungen, die voneinander getrennt sind, hintereinanderliegend angeordnet ist. Diese Einzelvertiefungen können bspw. als Bohrungen ausgebildet sein und einen kreisrunden Grundriss besitzen. Solche Gastaschen können Diffusionsbarrieren ausbilden, ohne dass ein durchgehender Graben gefertigt werden muss.

Der Flächenabschnitt 3 lässt sich in unterschiedliche Kreissegmente aufteilen. Ein erstes Kreissegment A, das sich etwa über einen Winkel von 90° erstreckt, weist auf seinem gesamten Bogenbereich zwei Kanäle 5 auf. Zwischen zwei ersten Kreissegmenten A erstreckt sich ein zweites Kreissegment B, durch welches sich genau ein Kanal 5 hindurch erstreckt. Beim Ausführungsbeispiel liegt die Vertiefung 10 bereichsweise im ersten Kreissegment A und bereichsweise im zweiten Kreissegment B.

Es wird als vorteilhaft angesehen, wenn sich das radial innere Ende 17 der Vertiefung 10 in einem ersten Kreissegment A und das radial äußere Ende 17' der Vertiefung 10 in einem anderen ersten Kreissegment A befindet, so dass sich die Vertiefung 10 durch ein zweites Kreissegment B erstreckt.

Bei dem in der Figur 3 dargestellten Ausführungsbeispiel liegt das radial äußere Ende 17' der Vertiefung 10 radial innerhalb des radial äußeren Endes 6' des Kanals 5.

Die Kanäle 5 und die Vertiefungen 10 bilden hier eine dreizählige Symmetrie um das Zentrum Z.

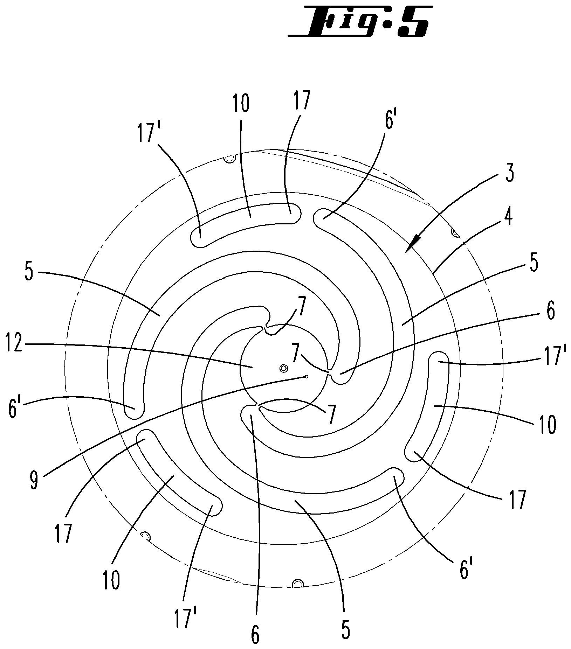

Bei dem in der Figur 5 dargestellten Ausführungsbeispiel schließen sich die Vertiefungen 10 an die Kanäle 5 an. Sie liegen auf einer verlängerten Spiralbogenlinie, auf der der Kanal 5 verläuft. Sie schließen sich hier an das radial außenliegende Ende 6' des Kanales 5 an. Auch hier ist eine dreizählige Symmetrie gegeben. Die Vertiefung 10 kann sich hier entweder auf einer Spirallinie oder auf einer Kreisbogenlinie erstrecken.

Bei dem in der Figur 6 dargestellten Ausführungsbeispiel schließen sich die Vertiefungen 10 ebenfalls den radial äußeren Enden 6' der Kanäle 5 an, liegen jedoch radial einwärts versetzt. Die Vertiefung 10 kann sich hier auf einer Spirallinie oder auf einer Kreisbogenlinie erstrecken.

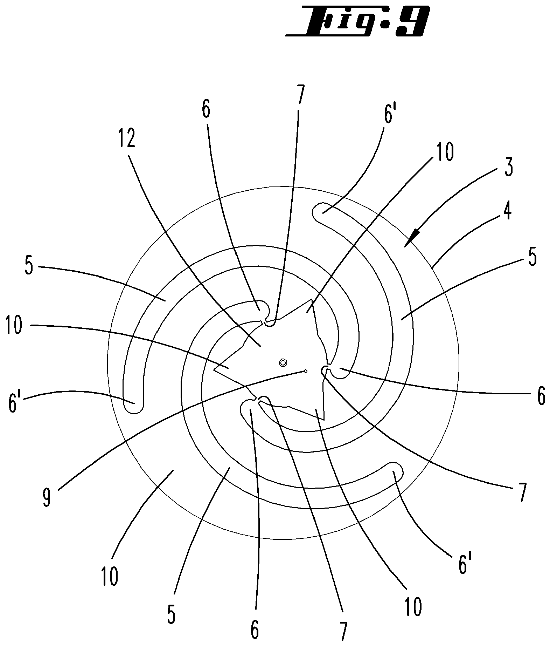

Bei dem in der Figur 9 dargestellten Ausführungsbeispiel sind die Vertiefungen 10 mit der Gasverteilausnehmung 12 strömungsverbunden. Die Vertiefungen 10 haben einen im Wesentlichen dreieckigen Grundriss, sind allerdings so angeordnet, dass durch sie nur eine nicht nennenswerte Gasströmung hindurchtritt. Wie bei den vorhergehenden Ausführungsbeispielen auch können in den Vertiefungen 10 auch Einsätze stecken. Bei diesem Ausführungsbeispiel sind die Vertiefungen 10 mit dem Gas zum Drehantrieb des Substrathalters strömungsverbunden. Auch hier besitzt die Anordnung der Vertiefungen 10 die gleiche Symmetriezähligkeit wie die Anordnung der Kanäle 5.

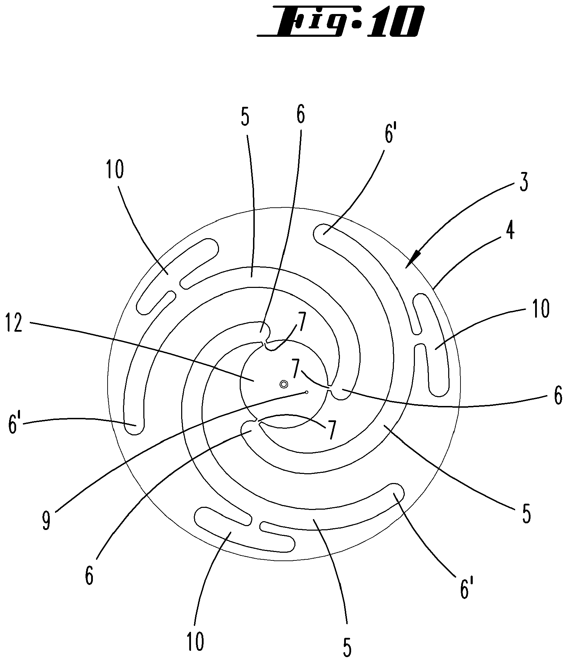

Bei dem in der Figur 10 dargestellten Ausführungsbeispiel ist eine im Randbereich längliche Vertiefung 10 mit einem Kanal 5 strömungsverbunden. Auch hier können in den Vertiefungen 10 Einsätze stecken. Es kann hier auch vorgesehen sein, dass die Vertiefungen so ausgebildet sind, dass in ihnen steckende Einsätze die Wand eines Kanales 5 ausbilden.

Bei dem in der Figur 11 dargestellten Ausführungsbeispiel sind mehrere Vertiefungen 10 jeweils dreieckförmig ausgestaltet. Auch bei dem in den Figuren 10 und 11 dargestellten Ausführungsbeispiel können in den Vertiefungen 10 Einsätze stecken. Die Gasverteilausnehmung 12 geht hier ohne eine Verengung in den Kanal 5 über.

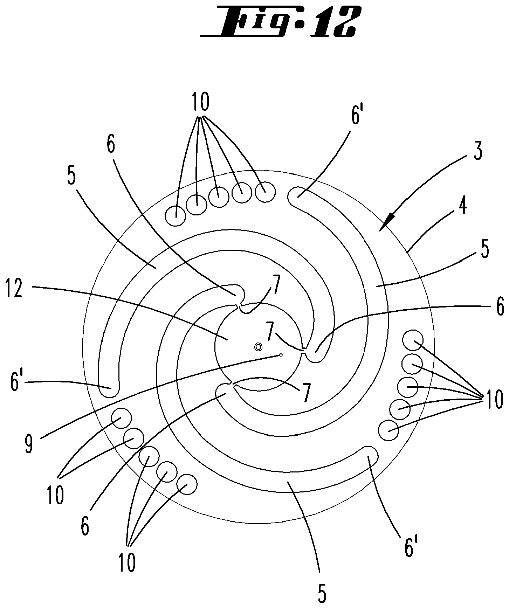

Auch bei dem in der Figur 12 dargestellten Ausführungsbeispiel können in den Vertiefungen 10 Einsätze stecken. Hier sind mehrere einen kreisförmigen Grundriss aufweisende Vertiefungen 10 in der Art einer Reihe hintereinander angeordnet. Die dort von Sackbohrungen ausgebildeten Vertiefungen 10 erstrecken sich entlang einer Bogenlinie oder einer Geraden, die in azimutaler Richtung verläuft.

Bei allen Ausführungsbeispielen kann sich die Vertiefung 10 auch auf einer zur Spirallinie der Kanäle der Kanäle 5 gegenläufigen Spirale erstrecken. Die Vertiefung kann ein länglicher Schlitz sein, wobei die Länge um ein Mehrfaches größer ist als die Schlitzbreite. Die Vertiefung kann aber auch eine freie Umrisskontur aufweisen.

Sofern vorstehend von Vertiefungen 10 die Rede ist, umfasst die Beschreibung auch solche Ausführungsbeispiele, bei denen in den Vertiefungen 10 nicht nur Einsätze stecken, sondern auch solche Ausführungsbeispiele, bei denen die Bezugsziffer 10 Erhebungen bezeichnet, die in den Flächenabschnitten 3 wurzeln und die eine Bodenfläche aufweisen, die oberhalb der ebenen Fläche des Flächenabschnittes 3 verlaufen. Durch Weglassen einzelner Beeinflussungselemente kann die Anordnung der Beeinflussungselemente auch eine nichtsymmetrische Anordnung werden.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können, nämlich:

Ein Suszeptor, der dadurch gekennzeichnet ist, dass in dem Flächenabschnitt 3 ein oder mehrere die lokale Wärmeübertragung beeinflussende Beeinflusselemente angeordnet sind, die als Erhebungen, offene Vertiefungen 10 in der Ebene oder als in den Vertiefungen 10 steckende Einsätze 11 ausgebildet sind.

Ein Suszeptor, der dadurch gekennzeichnet ist, dass Beeinflussungselemente 10, 11 und Kanäle 5 in azimutaler Richtung nebeneinanderliegend angeordnet sind.

Ein Suszeptor, der dadurch gekennzeichnet ist, dass die Erhebungen oder die Vertiefungen 10, insbesondere solche, in denen Einsätze 11 stecken, räumlich von den Kanälen 5 beabstandet sind oder räumlich mit den Kanälen 5 verbunden sind.

Ein Suszeptor, der dadurch gekennzeichnet ist, dass sich die auf einer Bogenlinie angeordneten Beeinflussungselemente 10, 11 über einen Kreisbogenwinkel um das Zentrum Z von mindestens 40°, bevorzugt 60°, und insbesondere 80° erstrecken.

Ein Suszeptor, der gekennzeichnet ist durch eine mehrzählig symmetrische Anordnung der Kanäle 5 und der Beeinflussungselemente 10, 11 um das Zentrum Z.

Ein Suszeptor, der dadurch gekennzeichnet ist, dass die Einspeiseöffnung (9) bezogen auf das Zentrum des kreisförmigen Flächenabschnittes (3) in eine zentrale Gasverteilausnehmung (12) mündet, die mit sich in Radialrichtung erstreckenden Kanalöffnungen (7) mit den insbesondere sich auf einer Spiralbogenlinie erstreckenden Kanälen (5) verbunden sind.

Ein Suszeptor, der dadurch gekennzeichnet ist, dass die als Erhebungen oder Vertiefungen 10 ausgebildeten Beeinflussungselemente einen geschlossenen Boden aufweisen, der von einer ununterbrochenen Wandung umgeben ist, die sich vom Boden der Erhebung oder Vertiefung 10 bis zum Rand der Ebene erstreckt.

Ein Suszeptor, der dadurch gekennzeichnet ist, dass die Einsätze 11 aus einem Werkstoff gefertigt sind, der eine andere spezifische Wärmeleitfähigkeit aufweist als der Suszeptor 1.

Ein Suszeptor, der dadurch gekennzeichnet ist, dass mehrere, insbesondere kreisförmige Vertiefungen 10, insbesondere mit darin steckenden Einsätzen 11 in azimutaler Richtung hintereinanderliegend angeordnet sind.

Ein Suszeptor, der dadurch gekennzeichnet ist, dass die Vertiefungen 10 einen Mehrkantgrundriss aufweisen.

Ein Suszeptor, der dadurch gekennzeichnet ist, dass die Tiefe der Vertiefung 10 vom Zentrum des Flächenabschnittes 3 hin zum Rand des Flächenabschnittes 3 abnimmt.

Ein Suszeptor, der gekennzeichnet ist durch erste Kreissektoren A um das Zentrum Z, durch welche sich mindestens zwei Kanäle 5 erstrecken und durch zweite Kreissektoren B um das Zentrum Z, durch welche sich nur ein Kanal 5 erstreckt, wobei die Winkelsumme aller ersten Kreissektoren A >180° und/oder die Winkelsumme aller zweiten Kreissektoren B >90° ist und/oder die Winkelsumme aller ersten Kreissektoren A größer ist als die Winkelsumme aller zweiten Kreissektoren B, wobei insbesondere in zumindest einem, bevorzugt in jedem ersten Kreissektor A zwischen den mindestens zwei Kanälen 5 oder radial außerhalb des radial äußersten Kanals 5 sich zumindest über einen Teilsektor ein Beeinflussungselement 10, 11 erstreckt und/oder wobei in zumindest einem, bevorzugt in jedem zweiten Kreissektor B insbesondere radial innerhalb des Kanals 5 sich über zumindest einen Teilsektor, bevorzugt über den gesamten Sektor ein Beeinflussungselement 10,11 erstreckt und/oder wobei die Winkelsumme aller ersten Kreissektoren A um das Zentrum Z, durch welche sich zumindest zwei der Kanäle 5 erstrecken, größer als 180° ist und/oder wobei in zumindest einem, bevorzugt in jedem ersten Kreissektor A, zwischen den mindestens zwei Kanälen 5 oder radial außerhalb des radial äußersten Kanals 5 sich über zumindest einen Teilsektor ein Beeinflussungselement 10, 11 erstreckt.

Eine Verwendung, die gekennzeichnet ist durch einen Suszeptor in einem CVD-Reaktor, wobei der Flächenabschnitt 3 den Boden einer Tasche 16 ausbildet, in der ein Substrathalter 13 einliegt.

Eine Substrathalteranordnung, die dadurch gekennzeichnet ist, dass der Flächenabschnitt 3 den Boden einer Tasche 16 ausbildet, in der ein kreisscheibenförmiger Substrathalter 13 einliegt, der durch Einspeisen eines Spülgases durch die Einspeiseöffnung 9 auf einem Gaspolster aufliegend in eine Drehbewegung um das Zentrum Z bringbar ist.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren auch ohne die Merkmale eines in Bezug genommenen Anspruchs mit ihren Merkmalen eigenständige erfinderische Weiterbildungen des Standes der Technik, insbesondere um auf Basis dieser Ansprüche Teilanmeldungen vorzunehmen. Die in jedem Anspruch angegebene Erfindung kann zusätzlich ein oder mehrere der in der vorstehenden Beschreibung, insbesondere mit Bezugsziffern versehene und/oder in der Bezugsziffernliste angegebene Merkmale aufweisen. Die Erfindung betrifft auch Gestaltungsformen, bei denen einzelne der in der vorstehenden Beschreibung genannten Merkmale nicht verwirklicht sind, insbesondere soweit sie erkennbar für den jeweiligen Verwendungszweck entbehrlich sind oder durch andere technisch gleichwirkenden Mittel ersetzt werden können.

**Liste der Bezugszeichen**

| | | | |
|---|---|---|---|
| 1 | Suszeptor | A | Kreissektor |
| 2 | Breitseite | B | Kreissektor |
| 3 | Flächenabschnitt | Z | Zentrum |
| 4 | Begrenzungslinie | | |
| 5 | Kanal | | |
| 6 | radial inneres Ende | | |
| 6' | radial äußeres Ende | | |
| 7 | Kanalöffnung | | |
| 8 | Gaszuleitung | | |
| 9 | Einspeiseöffnung | | |
| 10 | Vertiefung | | |
| 10' | Boden | | |
| 10" | Wand | | |
| 11 | Einsatz | | |
| 12 | Gasverteilausnehmung | | |
| 13 | Substrathalter | | |
| 14 | Gaseinlassorgan | | |
| 15 | Deckplatte | | |
| 16 | Tasche | | |
| 17 | radial inneres Ende | | |
| 17' | radial äußeres Ende | | |

## Patentansprüche

1. Suszeptor (1) für einen CVD-Reaktor, bestehend aus einem flachen Körper (1) mit zumindest einem auf einer Breitseite (2) angeordneten kreisförmigen Flächenabschnitt (3), auf dem ein Substrathalter (13) gelagert ist, wobei der Flächenabschnitt (3) in Richtung auf den Substrathalter (13) offene Kanäle (5) aufweist, die mit einer am Ende einer Gaszuleitung (8) angeordneten Einspeiseöffnung (9) derart strömungsverbunden sind, dass durch Einspeisen eines Gasstroms in die jeweiligen Kanäle (5) der Substrathalter (13) in eine Lüftungsstellung angehoben und drehangetrieben wird, wobei in dem Flächenabschnitt (3) ein oder mehrere, die lokale Wärmeübertragung beeinflussende Beeinflussungselemente (10, 11) angeordnet sind, die als Erhebungen, offene Vertiefungen (10) in der Ebene oder als in den Vertiefungen (10) steckende Einsätze (11) ausgebildet sind, **dadurch gekennzeichnet, dass** die Beeinflussungselemente (10, 11) in azimutalen Zwischenräumen zwischen den Kanälen (5) angeordnet sind, wobei im Falle der Ausgestaltung der Beeinflussungselemente (10,11) als offene Vertiefung (10) ein Boden der Vertiefung (10) von einer sich zwischen Boden und Ebene kontinuierlich umlaufenden Wand umgeben ist.

2. Suszeptor nach Anspruch 1, **dadurch gekennzeichnet, dass** die Erhebungen oder die Vertiefungen (10), in denen Einsätze (11) stecken, räumlich von den Kanälen (5) beabstandet sind oder räumlich mit den Kanälen (5) verbunden sind.

3. Suszeptor nach einem der vorhergehenden Ansprüche, **dadurch gekennzeichnet, dass** sich die auf einer Bogenlinie angeordneten Beeinflussungselemente (10, 11) über einen Kreisbogenwinkel um das Zentrum (Z) von mindestens 40°, bevorzugt 60°, und insbesondere 80° erstrecken.

4. Suszeptor nach einem der vorhergehenden Ansprüche, **gekennzeichnet durch** eine mehrzählig symmetrische Anordnung der Kanäle (5) und der Beeinflussungselemente (10, 11) um das Zentrum (Z).

5. Suszeptor nach einem der vorhergehenden Ansprüche, **dadurch gekennzeichnet, dass** die Einspeiseöffnung (9) bezogen auf das Zentrum des kreisförmigen Flächenabschnittes (3) in eine zentrale Gasverteilausnehmung (12) mündet, die mit sich in Radialrichtung erstreckenden Kanalöffnungen (7) mit den sich auf einer Spiralbogenlinie erstreckenden Kanälen (5) verbunden sind.

6. Suszeptor nach einem der vorhergehenden Ansprüche, **dadurch gekennzeichnet, dass** die als Erhebungen oder Vertiefungen (10) ausgebildeten Beeinflussungselemente einen geschlossenen Boden aufweisen, der von einer ununterbrochenen Wandung umgeben ist, die sich vom Boden der Erhebung oder Vertiefung (10) bis zum Rand der Ebene erstreckt.

7. Suszeptor nach einem der vorhergehenden Ansprüche, **dadurch gekennzeichnet, dass** die Einsätze (11) aus einem Werkstoff gefertigt sind, der eine andere spezifische Wärmeleitfähigkeit aufweist, als der Suszeptor (1).

8. Suszeptor nach einem der vorhergehenden Ansprüche, **dadurch gekennzeichnet, dass** die Vertiefungen (10) einen Mehrkantgrundriss aufweisen.

9. Suszeptor nach einem der vorhergehenden Ansprüche, **dadurch gekennzeichnet, dass** die Tiefe der Vertiefung (10) vom Zentrum des Flächenabschnittes (3) hin zum Rand des Flächenabschnittes (3) abnimmt.

10. Suszeptor nach einem der vorhergehenden Ansprüche, **gekennzeichnet durch** erste Kreissektoren (A) um das Zentrum (Z), durch welche sich mindestens zwei Kanäle (5) erstrecken und durch zweite Kreissektoren (B) um das Zentrum (Z), durch welche sich nur ein Kanal (5) erstreckt, wobei die Winkelsumme aller ersten Kreissektoren (A) >180° und/oder die Winkelsumme aller zweiten Kreissektoren (B) >90° ist und/oder die Winkelsumme aller ersten Kreissektoren (A) größer ist als die Winkelsumme aller zweiten Kreissektoren (B), wobei insbesondere in zumindest einem, bevorzugt in jedem ersten Kreissektor (A) zwischen den mindestens zwei Kanälen (5) oder radial außerhalb des radial äußersten Kanals (5) sich zumindest über einen Teilsektor ein Beeinflussungselement (10, 11) erstreckt und/ oder wobei in zumindest einem, bevorzugt in jedem zweiten Kreissektor (B) insbesondere radial innerhalb des Kanals (5) sich über zumindest einen Teilsektor, bevorzugt über den gesamten Sektor ein Beeinflussungselement (10, 11) erstreckt und/oder wobei die Winkelsumme aller ersten Kreissektoren (A) um das Zentrum (Z), durch welche sich zumindest zwei der Kanäle (5) erstrecken, größer als 180° ist und/oder wobei in zumindest einem, bevorzugt in jedem ersten Kreissektor (A), zwischen den mindestens zwei Kanälen (5) oder radial außerhalb des radial äußersten Kanals (5) sich über zumindest einen Teilsektor ein Beeinflussungselement (10, 11) erstreckt.

11. Verwendung eines Suszeptors gemäß einem der vorhergehenden Ansprüche in einem CVD-Reaktor, wobei der Flächenabschnitt (3) den Boden einer Tasche (16) ausbildet, in der ein Substrathalter (13) einliegt.

12. Substrathalteranordnung mit einem Suszeptor (13) gemäß einem der vorhergehenden Ansprüche 1 bis 10, **dadurch gekennzeichnet, dass** der Flächenabschnitt (3) den Boden einer Tasche (16) ausbildet, in der ein kreisscheibenförmiger Substrathalter (13) einliegt, der durch Einspeisen eines Spülgases durch die Einspeiseöffnung (9) auf einem Gaspolster aufliegend in eine Drehbewegung um das Zentrum (Z) bringbar ist.

## Claims

1. A Susceptor (1) for a CVD reactor, consisting of a flat body (1) with at least one circular surface section (3) arranged on a broadside (2), on which a substrate holder (13) is mounted, the surface section (3) having channels (5) which are open in the direction of the substrate holder (13), which are flow-connected to an in-feed opening (9) arranged at the end of a gas supply line (8) in such a way that by feeding a gas flow into the respective channels (5) the substrate holder (13) is raised into a ventilation position and driven in rotation, wherein one or more influencing elements (10, 11) influencing the local heat transfer are arranged in the surface section (3), which are formed as elevations, open depressions (10) in the plane or as insert pieces (11) inserted in the depressions (10), **characterised in that in that** the influencing elements (10, 11) are arranged in azimuthal interspaces between the channels (5), wherein, in the case of the influencing elements (10, 11) being designed as an open depression (10), a bottom of the depression (10) is surrounded by a wall continuously running around between the bottom and the plane.

2. The susceptor according to claim 1, **characterised in that** the elevations or the depressions (10) in which inserts (11) are inserted are spatially spaced from the channels (5) or are spatially connected to the channels (5).

3. The susceptor according to one of the preceding claims, **characterized in that** the influencing elements (10,11), arranged on an arc line, extend about the centre (Z) over a circular arc angle of at least 40°, preferably 60°, and in particular 80°.

4. The susceptor according to any one of the preceding claims, **characterized by**, a multi-fold symmetrical arrangement of the channels (5) and the influencing elements (10, 11) about the centre (Z).

5. The susceptor according to any one of the preceding claims, **characterised in that** the in-feed opening (9), relative to the centre of the circular surface section (3), opens out into a central gas distribution recess (12), which is connected to channel openings (7) extending in the radial direction, to which the channels (5), extending along a spiral arc line, are connected.

6. The susceptor according to one of the preceding claims, **characterised in that** the influencing elements formed as elevations or depressions (10) have a closed bottom surrounded by an uninterrupted wall extending from the bottom of the elevation or depression (10) to the edge of the plane.

7. The susceptor according to one of the preceding claims, **characterised in that** the insert pieces (11) are made of a material which has a different specific thermal conductivity than the susceptor (1).

8. The susceptor according to one of the preceding claims, **characterised in that** the depressions (10) have a polygonal outline.

9. The susceptor according to one of the preceding claims, **characterised in that** the depth of the depression (10) decreases from the centre of the surface section (3) to the edge of the surface section (3).

10. The susceptor as claimed in one of the preceding claims, **characterized by**, first circular sectors (A) about the centre (Z), through which at least two channels (5) extend, and by second circular sectors (B) about the centre (Z), through which only one channel (5) extends, wherein the angular sum of all first circular sectors (A) is > 180°, and/or the angular sum of all second circular sectors (B) is > 90°, and/or the angular sum of all first circular sectors (A) is greater than the angular sum of all second circular sectors (B), wherein in particular in at least one, preferably in each, first circular sector (A), an influencing element (10, 11) extends between the at least two channels (5), or radially outside the radially outermost channel (5), over at least a sub-sector, and/or wherein in at least one, preferably in each, second circular sector (B), an influencing element (10, 11) extends, in particular radially inside the channel (5), over at least a sub-sector, preferably over the entire sector, and/or wherein the angular sum of all first circular sectors (A) about the centre (Z), through which at least two of the channels (5) extend, is greater than 180°, and/or wherein in at least one, preferably in each first circular sector (A), an influencing element (10, 11) extends between the at least two channels (5), or radially outside the radially outermost channel (5), over at least a sub-sector.

11. Use of a susceptor according to any one of the preceding claims in a CVD reactor, wherein the surface section (3) forms the floor of a pocket (16), in which a substrate holder (13) is positioned.

12. A substrate holder arrangement with a susceptor (13) according to one of the preceding claims 1 to 10, **characterised in that** the surface section (3) forms the floor of a pocket (16), in which a circular disc-shaped substrate holder (13) is positioned, supported on a gas cushion, which can be brought into rotation about the centre (Z) by feeding a purge gas in through the in-feed opening (9).

## Revendications

1. Suscepteur (1) destiné à un réacteur de dépôt chimique en phase vapeur (DCV), composé d'un corps plat (1) avec au moins une section de surface (3) circulaire disposée sur un côté large (2), sur laquelle est logé un support de substrat (13), sachant que la section de surface (3) comporte des canaux (5) ouverts en direction du support de substrat (13), qui sont reliés en écoulement à une ouverture d'entrée (9) disposée à l'extrémité d'un conduit d'alimentation de gaz (8) de telle manière que le support de substrat (13) est soulevé et entraîné en rotation dans une position de ventilation par introduction d'un courant de gaz dans les canaux (5) respectifs, sachant que dans la section de surface (3) sont disposés un ou plusieurs éléments d'influence (10, 11) influençant la transmission de chaleur locale, qui sont constitués sous la forme de bossages, de cavités ouvertes (10) dans le plan ou sous la forme d'insertions (11) s'emboîtant dans les cavités (10), **caractérisé en ce que** les éléments d'influence (10, 11) sont disposés dans des espaces intermédiaires azimutaux entre les canaux (5), sachant qu'en cas de configuration des éléments d'influence (10, 11) sous la forme de cavité ouverte (10), un fond de la cavité (10) est entouré d'une paroi passant en continu entre le fond et le plan.

2. Suscepteur selon la revendication 1, **caractérisé en ce que** les bossages ou les cavités (10) dans lesquelles s'emboîtent les insertions (11), sont éloignés dans l'espace des canaux (5) ou sont reliés dans l'espace aux canaux (5).

3. Suscepteur selon l'une quelconque des revendications précédentes, **caractérisé en ce que** les éléments d'influence (10, 11) disposés sur une ligne d'arc s'étendent sur un angle d'arc de cercle autour du centre (Z) d'au moins 40°, de préférence 60°, et en particulier de 80°.

4. Suscepteur selon l'une quelconque des revendications précédentes, **caractérisé par** une disposition en majorité symétrique des canaux (5) et des éléments d'influence (10, 11) autour du centre (Z).

5. Suscepteur selon l'une quelconque des revendications précédentes, **caractérisé en ce que** l'ouverture d'entrée (9) débouche dans un évidement de répartition de gaz (12) central par rapport au centre de la section de surface (3) de forme circulaire, qui est relié avec les ouvertures de canal (7) s'étendant en direction radiale aux canaux (5) s'étendant sur une ligne d'arc en spirale.

6. Suscepteur selon l'une quelconque des revendications précédentes, **caractérisé en ce que** les éléments d'influence constitués sous la forme de bossages ou de cavités (10) comportent un fond fermé, qui est entouré par une cloison ininterrompue, qui s'étend du fond du bossage ou de la cavité (10) jusqu'au bord du plan.

7. Suscepteur selon l'une quelconque des revendications précédentes, **caractérisé en ce que** les insertions (11) sont fabriquées à partir d'un matériau qui présente une autre thermoconductibilité spécifique que le suscepteur (1) .

8. Suscepteur selon l'une quelconque des revendications précédentes, **caractérisé en ce que** les cavités (10) comportent un profil d'ensemble polygonal.

9. Suscepteur selon l'une quelconque des revendications précédentes, **caractérisé en ce que** la profondeur des cavités (10) diminue du centre de la section de surface (3) au bord de la section de surface (3).

10. Suscepteur selon l'une quelconque des revendications précédentes, **caractérisé par** des premiers secteurs de cercle (A) autour du centre (Z) à travers lesquels s'étendent au moins deux canaux (5) et par des deuxièmes secteurs de cercle (B) autour du centre (Z) à travers lesquels ne s'étend qu'un canal (5), sachant que la somme des angles de tous les premiers secteurs de cercle (A) est > 180° et/ou la somme des angles de tous les deuxièmes secteurs de cercle (B) est > 90° et/ou la somme des angles de tous les premiers secteurs de cercle (A) est supérieure à la somme des angles de tous les deuxièmes secteurs de cercle (B), sachant en particulier que dans au moins un, de préférence dans chaque premier secteur de cercle (A) entre au moins deux canaux (5) ou radialement en dehors du canal (5) radialement le plus extérieur s'étend un élément d'influence (10, 11) sur au moins un secteur partiel et/ou sachant que dans au moins un, de préférence dans chaque deuxième secteur de cercle (B) en particulier radialement à l'intérieur du canal (5) s'étend un élément d'influence (10, 11) sur au moins un secteur partiel, de préférence sur tout le secteur et/ou sachant que la somme des angles de tous les premiers secteurs de cercle (A) autour du centre (Z) à travers lesquels s'étendent au moins deux des canaux (5), est supérieure à 180° et/ou sachant que dans au moins un, de préférence dans chaque premier secteur de cercle (A), entre au moins deux canaux (5) ou radialement en dehors du canal (5) radialement le plus extérieur s'étend un élément d'influence (10, 11) sur au moins un secteur partiel.

11. Utilisation d'un suscepteur selon l'une quelconque des revendications précédentes dans un réacteur de dépôt chimique en phase vapeur, sachant que la section de surface (3) constitue le fond d'une poche (16) dans laquelle s'insère un support de substrat (13).

12. Système de support de substrat avec un suscepteur (13) selon l'une quelconque des revendications précédentes 1 à 10, **caractérisé en ce que** la section de surface (3) constitue le fond d'une poche (16) dans laquelle s'insère un support de substrat (13) de forme discoïdale, qui peut être placé dans un mouvement de rotation autour du centre (Z) par introduction d'un gaz d'entraînement à travers l'ouverture d'introduction (9) reposant sur un coussin gazeux.
